# EUROPEAN PATENT SPECIFICATION

(11) **EP 2 823 357 B1**
(45) Date of publication and mention of the grant of the patent: **02.03.2016**
(21) Application number: 13710287.7
(22) Date of filing: 08.03.2013
(51) Int. Cl.: G03F 7/00, B29C 33/38, B29C 33/72, B29C 33/42, B82Y 10/00, B82Y 40/00, B29C 45/26

(54) **A METHOD FOR MANUFACTURING A TOOL PART FOR AN INJECTION MOLDING PROCESS, A HOT EMBOSSING PROCESS, A NANO-IMPRINT PROCESS, OR AN EXTRUSION PROCESS**
VERFAHREN ZUR HERSTELLUNG EINES WERKZEUGTEILS FÜR EIN SPRITZGIESSVERFAHREN, HEISSPRÄGEVERFAHREN, NANOPRÄGEVERFAHREN ODER EXTRUSIONSVERFAHREN
PROCÉDÉ DE FABRICATION D'UNE PIÈCE D'OUTIL POUR PROCÉDÉ DE MOULAGE PAR INJECTION, PROCÉDÉ DE GAUFRAGE À CHAUD, PROCÉDÉ DE NANO-IMPRESSION OU PROCÉDÉ D'EXTRUSION

(30) Priority: 09.03.2012 EP 12158834; 09.03.2012 US 201261608828 P
(43) Date of publication of application: 14.01.2015
(73) Proprietor: Danmarks Tekniske Universitet, 2800 Lyngby (DK); NIL Technology APS, 2800 Kgs. Lyngby (DK)
(72) Inventor: TABORYSKI, Rafael, DK-2880 Bagsværd (DK); SØGAARD, Emil, DK-2500 Valby (DK); SMISTRUP, Kristian, DK-2100 Copenhagen Ø (DK)
(74) Representative: Plougmann & Vingtoft A/S
(86) International application number: PCT/DK2013/050060
(87) International publication number: WO 2013/131525

(56) References cited:
- WO-A1-02/22304
- US-A- 5 674 592
- US-A1- 2007 115 554
- US-A1- 2011 287 203

## Description

### FIELD OF THE INVENTION

The present invention relates to a method for manufacturing a tool part for an injection molding process, a hot embossing process, a nano-imprint process, or an extrusion process. The invention also relates to corresponding tool part, e.g. a tool part capable of producing a self-cleaning surface in an object.

### BACKGROUND OF THE INVENTION

Injection molded polymer parts with micro- or nano-structured surfaces, has the ability to introduce wide range of new functionalities. Many consumer products today, use chemical coatings to lower adhesion or to repel water, these are potentially unhealthy or toxic. Surfaces with self-cleaning nano and microstructures that imitate the lotus flower. This is of high relevance for the medical and food producing industries. For example, medical and food containers can be designed so they can be completely emptied. Therefore, none of the expensive medicine or food is wasted. Furthermore, self-cleaning surfaces are relevant for hearing aids and medical equipment such as endoscopes.

Various solutions have been suggested in the past in order to meet this demand for self-cleaning surfaces. Solutions are available but they are either rather complicated to manufacture due to the intensive need for lithographic processing , or they are not sufficiently durable over time, e.g. by being dependent on chemical coatings that are worn off during use. Some chemical coatings used in consumer products today use e.g. fluorine containing chemical coatings, which are potentially unhealthy or toxic.

US patent application 2002/0164443 for example discloses an injection molding processes with the purpose of creating lotus-like structures with various mathematically based structures. Initially, a master structure is made which is then transferred into an injection-molding tool, for example by a LIGA process. The production of the master structure is however quite time consuming due to the intensive need for complex, and therefore costly, lithography steps for designing the proposed mathematical structures resulting in a lotus-like functionality in the final product.

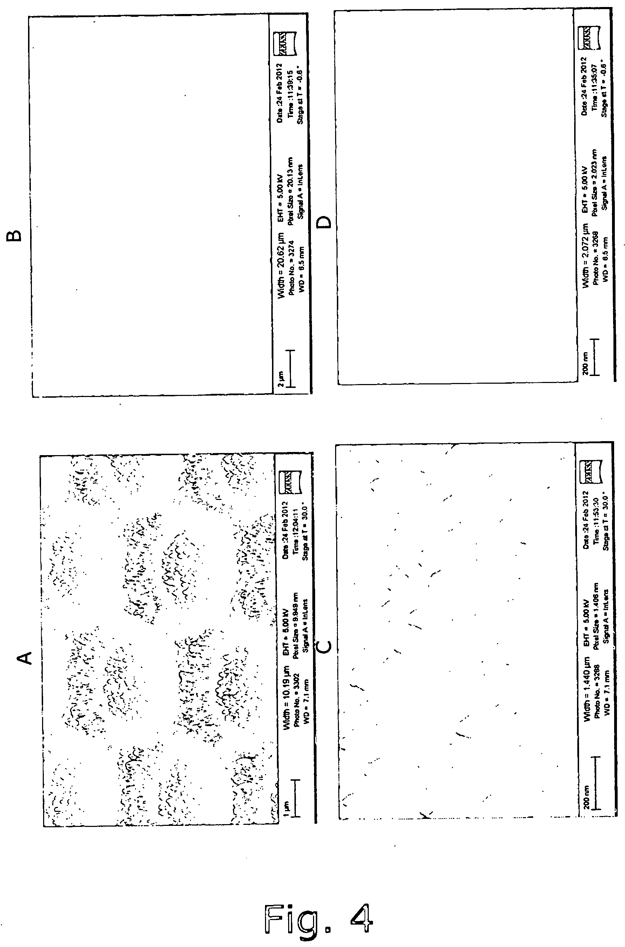

US patent application 2007/115554 relates to an antireflective viewing surface with a textured layer disposed upon the viewing surface; wherein the textured layer comprises randomly distributed protrusions having randomly distributed dimensions that are smaller than the wavelength of light. Disclosed herein is a method of manufacturing an antireflective viewing surface comprising: electroforming a metal upon a first template to form an electroformed metal template; wherein the first template comprises random, columnar structures; disposing a layer of a polymeric resin on a viewing surface; pressing the electroformed metal template against the viewing surface; and solidifying the polymeric resin. The layer having randomly distributed protrusions of e.g. titanium dioxide or carbon nanotube is grown on the surface by conventional methods. The protrusions have dimensions smaller than the wavelength of light in order to provide anti-reflection. The textured layer can be transferred from a so-called first template to an electroformed metal template that can be used for subsequent molding, or forming, cf. figure 4 and the corresponding description [0058]. The growth of such protrusions is typically somewhat time-consuming thereby representing a bottle neck for manufacturing use.

Hence, an improved method would be advantageous, and in particular a more efficient and/or reliable method would be advantageous.

### OBJECT OF THE INVENTION

It is a further object of the present invention to provide an alternative to the prior art.

In particular, it may be seen as an object of the present invention to provide a method that solves the above mentioned problems of the prior art with complex and/or cost intensive manufacturing of tools part having functional surfaces.

### SUMMARY OF THE INVENTION

Thus, the above described object and several other objects are intended to be obtained in a first aspect of the invention by providing a method for manufacturing a tool part for an injection molding process, a hot embossing process, nano-imprint process or an extrusion process, the method comprises providing a semiconductor master structure with a surface area comprising nanometre-sized protrusions with a minimum density of approximately 10⁵ protrusions/mm², the protrusions being positioned in a non-periodic, irregular pattern, said protrusions being created by a process comprising:
alternating passivation and etching into the master structure, and/or
simultaneous passivation and etching into the master structure, and/or
etching into the master structure,
transferring the master structure into a metal insert, the metal insert having a corresponding nanometre-sized pattern from said protrusions, and adapting the metal insert into a tool part for enabling nanometre-sized patterns being formed by the tool part.

The invention is particularly, but not exclusively, advantageous for obtaining a tool part in a more simple way than hitherto possible due the easier and/or faster way of manufacturing the master structure in a semiconductor material such as a silicon wafer. It is a further advantage of the present invention that it provides an advantageous way of making tools capable of producing self-cleaning surfaces without the need for chemical coating.

Furthermore, an injection molding tool part according to the present invention can essentially manufacture final products in any thermoplastic material suitable for injection molding which may open up for wide spread application of the present invention, e.g. in every day consumer products already manufactured by injection molding.

In the context of the present invention, it is to be understood that the three options, (1, 2 and 3) for creation of protrusions:
1) alternating passivation and etching into the master structure, and/or
2) simultaneous passivation and etching into the master structure, and/or
3) etching into the master structure,
can be applied solely (i.e. only option 1, 2 or 3), in combination (i.e. 1 and 2, or 1 and 3, or 1 and 3), such as a period of performing option 1 followed by another period with option 2, etc., and a combination of all 3 options (1, 2, and 3), such as various combination of periods with options 1, 2, and 3 for creation of protrusions, as the skilled person will readily understand once the general principle of the invention is comprehended.

Notice that the present invention applies various etching processes, which is quite different from US patent application 2007/115554 were the random protrusions are grown, typically over several hours. The present invention is typically order of magnitude faster and less complex to implement, in particular when implemented on a semiconductor wafer or similar in a cleanroom environment. In general, the present invention relates to a master structure made of a semiconductor material.

The present invention is further advantageous over US2007/115554 in that the master origination is compatible with standard processes available in most cleanrooms for semiconductor fabrication, the term 'origination' meaning the way of modifying the master structure (in short the 'master') into a desired shape. Moreover, the present invention does not include nanoparticle coatings with potential health hazards, as the master structure is formed by structuring the substrate surface exclusively, or predominately, by etching processes in the most preferred embodiments. Finally, the present invention is primarily focussed on anti-wetting functionalities, though the present invention may also be applied in order to implement anti-reflection properties in the final product being manufactured by the tool according to the first aspect of the invention.

The present invention relates generally to tool parts for application in an injection molding process, a hot embossing process or an extrusion process, or other similar processes or equivalent manufacturing processes.

The master structure may have alternatively have a surface area comprising nanometre-sized protrusions with a minimum density of approximately 10⁶ protrusions/mm². It is to be understood that the density is calculated on an average basis as will be appreciated by a person working with micro-technologies.

The concept of a non-period, irregular pattern is to be understood by the skilled person as seen on as seen or viewed on a nanometer scale, e.g. using scanning electron microscopy (SEM) or an atomic force microscopy (AFM) as it will be demonstrated in the detailed description of the invention below. Using for example a pixel size of approximately 2-20 nm in SEM, the master structure will be shown to have a protrusion distribution with such a pattern.

The process for creating said nano-meter sized protrusions using alternating, and/or simultaneous, passivation and etching into the master structure may preferably take place in a vacuum chamber, more preferably the entire process of creating the protrusions takes place in a single vacuum chamber in order to facilitate fast processing i.e. without any significant delay between etching and passivation. Thus, by performing the process in a single process the invention may facilitate that the master structure is made in a quick way, e.g. less than 60 minutes, less than 30 minutes, or less than 10 minutes. Typically, the alternating process of passivation and etching into the master structure may be repeated a plurality of times, such as least 10 times, 50 times, 100 times, or 500 times.

Similarly, if the process for creating said nano-meter sized protrusions in a non-period, irregular pattern is obtained using etching into the master structure, e.g. by a chemical wet etching process in strong acid or base, the process may also be take place in a fast and advantageous way.

The step of transferring the master structure into a metal insert, the metal insert having a corresponding nanometre-sized pattern from said protrusions can be made either by a positive transfer, or by a negative transfer of the master structure as the skilled person would readily understood once the general teaching and principle of the present inventions has been appreciated by the skilled person. There may be several intermediate steps in the transferring process. There may also be produced several duplicates ('families') of the same master structure.

The step of adapting the metal insert into a tool part can be performing in various ways, e.g. by mechanical securing the metal insert into the tool part. The adaption must be made so as to enable that the nanometre-sized patterns of the insert is replicated or formed into the moulded product by the tool part.

Preferably, the process for creating the protrusions may result in a random shape and/or a random position with respect to an individual protrusion i.e. essentially the process may be viewed as a non-deterministic process, though of course some overall control of the average shape and position of the protrusions are possible. Nevertheless, the advantage in speed of manufacturing outweighs this apparent disadvantage. More specifically, the dimensions of the protrusions may defined by corresponding intervals for each dimension, each dimension being randomly scattered within a corresponding interval, preferably at least one dimension having a scattering of at least 50% of the average value e.g. height of the protrusion may be a height range of : average height +/- 100%, 80%, 60%, 40%, 20% etc. or a thickness, or width, with a thickness range of : average thickness +/- 100 %, 80%, 60%, 40%, 20% etc.

Alternatively, the process may be defined by a set of global process parameters, said parameters being common for the creation of at least a main portion of the protrusions such as gas, bias, temperature, pressure, switching frequency etch/passivation. Thus, there are no process parameters related to the individual protrusions like for instance in conventional lithography. Thus, the process may be defined by a set of process parameters, said parameters not being directly related to the size and/or the position of the individual protrusion.

It may be said that the nanometer-sized protrusions may be created by the process does not require any lithographic process step for defining shape and/or position of the protrusions, at least for the main part of the protrusions. The main part of the protrusions may e.g. 90% or 95%.

Typically, the passivation may comprise the formation of an inert polymer, or an oxide, on the master structure, using e.g. a fluoro-carbon like C3F for creating such a temporarily layer. Preferably, the etching may comprise reactive ion etching (RIE) in the master structure e.g. Bosch or cryogenic.

Alternatively or additionally, the etching may comprise a wet chemical etching such as a strong base, or acid, e.g. KOH. The master structure, e.g. a silicon wafer, is submerged in the etching liquid which makes the surface rough or etches in certain crystallographic plane. A mask may be used or not. A possible mask is a photoresist or SiO₂/Nitride.

Alternatively, wherein the etching may comprise laser-assisted etching, such as femtosecond pulse laser process as described by Crouch et al. in Appl. Phys. Lett. 84, 1850 (2004); doi: 10.1063/1.1667004.

Typically, the master structure is a semiconductor wafer. Thus, in one embodiment, the master structure may be a silicon wafer, and preferably the nanometer-sized protrusions constitute nano-grass and/or black silicon. Black silicon is a known surface type produced by e.g. repeated directional etching and passivation resulting in large amount of needle-like, or spike-like, structures pointing away from the surface, the surface has a relatively low reflectivity (hence the name). Nano-grass may similarly be defined as a large amount of protruding, randomly oriented structures resembling to some extent natural grass as seen in a microscopic view.

Typically, the nanometer-sized protrusions may have an aspect ratio (A), i.e. height / width of structure on average, of minimum 10, 1, 0.1 or 0.01. Alternatively, the nanometer-sized protrusions may have an aspect ratio (A), i.e. height / width of structure on average, of maximum 10, 1, 0.1 or 0.01.

Typically, the nanometer-sized protrusions have a density within an interval of 10⁵ - 10¹⁰/mm², preferably within an interval of 10⁵ - 10⁷/mm².

Advantageously, the nanometer-sized protrusions may have an average height of minimum 10 nm, 20 nm, 30 nm, 40 nm, 50 nm or 100 nm, 200 nm, or 300 nm. Alternatively, the nanometer-sized protrusions may have an average height of maximum 10 nm, 20 nm, 30 nm, 40 nm, 50 nm or 100 nm, 200 nm, or 300 nm.

The dimensions of the protrusions should, on one hand satisfy the functional purpose of e.g. providing a self-cleaning surface by having sufficiently high protrusions, and, on one the other hand, being within a feasible level of manufacturing and durability. Thus, too high protrusions may be difficult to mold, e.g. un-molding, and may wear off quickly during mechanical stresses during applications.

In one preferred embodiment, the master structure may comprise a hierarchical structure with a plurality of surface areas comprising nanometre-sized protrusions with a minimum density of 10⁵ protrusions/mm², and a plurality of surface areas comprising micrometer-sized surface structures, either protruding away from the surface and/or being holes in the surface, the said structures preferably having a characteristic length scale of 1-1000 micrometer, more preferably 1-100 micrometre, even more preferably 2-50 micrometer. Such a hierarchical structure is particularly advantageous for obtaining self-cleaning functional properties of the resulting surface. The nanometre-sized protrusions may cover, i.e. being positioned upon, both the micrometer-sized surface structures protruding away from the surface and/or the holes in the surface, and possibly the surface not being protruded or lowered relative to the overall or average surface level.

Beneficially, the step of transferring the master structure into a metal insert may be performed by method chosen from the list consisting of:
- material deposition, such as electroplating
- imprint lithography,
- soft lithography,
- hot embossing combined with etching, and
- casting.

Other available transferring techniques may readily be considered by the skilled person once the general teaching and principle of the present invention is acknowledged. Thus, both inverse transfer (negative) and direct transfer (positive) of the master is envisioned within the context of the present invention.

Particularly, the transferring the master structure into a metal insert may be performed by electrochemical deposition of a shim on the master structure, the shim being used on, or in, the metal insert as a part of the tool part. Beneficially, the manufacturing may include duplication of the master into a so-called 'family' of shims for facilitating high speed productions.

In a second aspect, the invention relates to a tool part having a metal insert with nano-meter-sized protrusions, the protrusions being manufactured according to the first aspect.

In a third aspect, the present invention relates to a polymer product manufactured by a tool according to the second aspect.

Such a product is particularly beneficial in that the fabrication of a hierarchical surface structure may comprise both micro and nanostructures, where the microstructure is e.g. composed of holes rendering the surface repellent such that liquid is prevented from wetting the surface inside the holes due to surface tension when the entire surface is covered by liquid. This will of course depend on the properties of the master structure as will readily be understood.

Alternatively or additionally, the combination of micro- and nanostructures may ensure that the structured surface is self-cleaning, e.g. such that sessile drops will form high contact angles with the surface, as measured with water (WCA), and in addition the contact angle hysteresis between advancing and receding contact angle is small. A high contact angle may be considered to be above 130° and more preferably above 150°, while a low contact angle hysteresis may be considered to be below 30°, and more preferably below 5°. An advantageous use of such a surface will be the inside of liquid containers, e.g. paint, dairy products, or cosmetics, and will ensure that the liquid container can be emptied and/or cleaned more easily.

The individual aspects of the present invention may each be combined with any of the other aspects. These and other aspects of the invention will be apparent from the following description with reference to the described embodiments.

### BRIEF DESCRIPTION OF THE FIGURES

The invention will now be described in more detail with regard to the accompanying figures. The figures show one way of implementing the present invention and is not to be construed as being limiting to other possible embodiments falling within the scope of the attached claim set.
Figure 1 shows a schematic overview of the three main steps of the invention; providing a master structure, transferring to a metal insert, and adapting to a tool part,
Figure 2 shows schematically a more detailed illustration of a method according to the present invention,
Figure 3 shows three SEM images of a master structure in silicon, a Nickel shim where the hierarchical structure with nanometre-sized and micrometre-size pattern has transferred to, and a resulting molded polymer product,
Figures 4 and 5 shows more detailed SEM images of a silicon master structure according to the present invention,
Figure 6 shows a more detailed AFM image of silicon master structure,
Figure 7 shows SEM images of a Nickel metal insert according to the present invention,
Figure 8 shows a more detailed AFM image of a Nickel metal insert according to the present invention,
Figures 9 and 10 shows SEM images of a molded polymer product manufactured with tool according to the present invention,
Figure 11 illustrates the result of the wetting experiment for a flat structure without the invention (left) and a polymer product manufactured with tool according to the present invention (right), and
Figure 12 is a schematic system-chart representing a method according to the invention.

### DETAILED DESCRIPTION OF AN EMBODIMENT

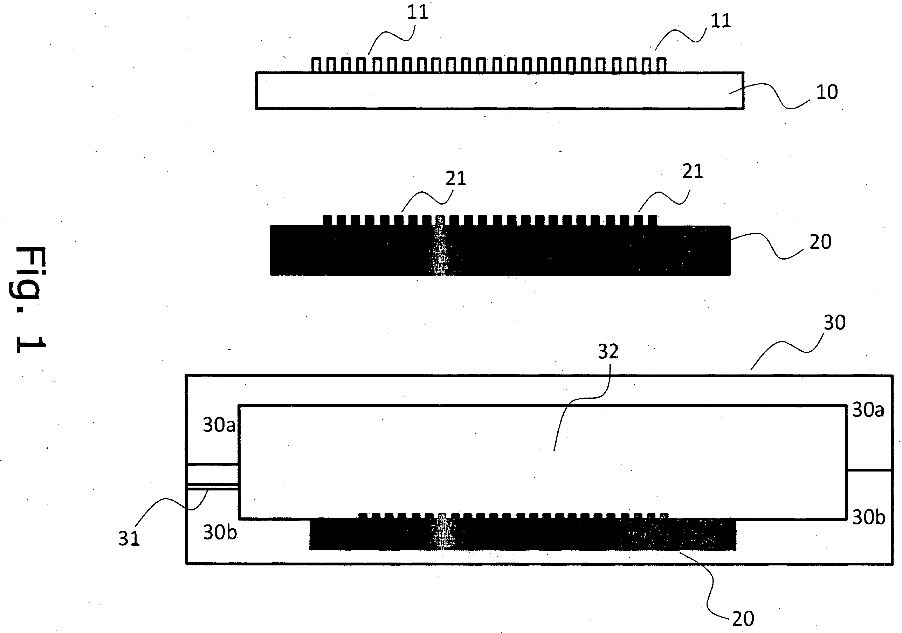

Figure 1 shows a schematic overview of the three main steps forming part of the invention; providing a master structure 10, transferring to a metal insert 20, and adapting to a tool part 30.

The master structure 10 has a surface area comprising nanometre-sized protrusions 11 (not to scale) with a minimum density of approximately 10⁵ protrusions/mm², the protrusions being positioned in a non-periodic, irregular pattern i.e. essentially a random or non-deterministic pattern, said protrusions being created by a process comprising:
1) alternating passivation and etching into the master structure, e.g. reactive ion etching by the so-called Bosch method, and/or
2) simultaneous passivation and etching into the master structure, e.g. reactive ion etching by the so-called cryogenic method, and/or
3) etching into the master structure, e.g. by a chemical wet etching.

Subsequently, the pattern of the protrusions 11 is transferred from the master structure 10 into a metal insert 20, the metal insert having a corresponding nanometre-sized pattern 21 from said protrusions, such as a LIGA technique or other similar or equivalent techniques.

Finally, the step of adapting the metal insert 20 into a tool part 30 is performed for enabling nanometre-sized patterns being formed by the tool part 30. In Figure 1, the tool part is shown to have two half-parts 30a and 30b, respectively, where the metal insert 20 is positioned in the lower part 30b. However, the present invention is contemplated also to include a plurality of metal inserts like the one shown in Figure 1. Also schematically indicated are feeding channel 31 for supplying molten polymer under pressure into the molding chamber 32 of the tool 30.

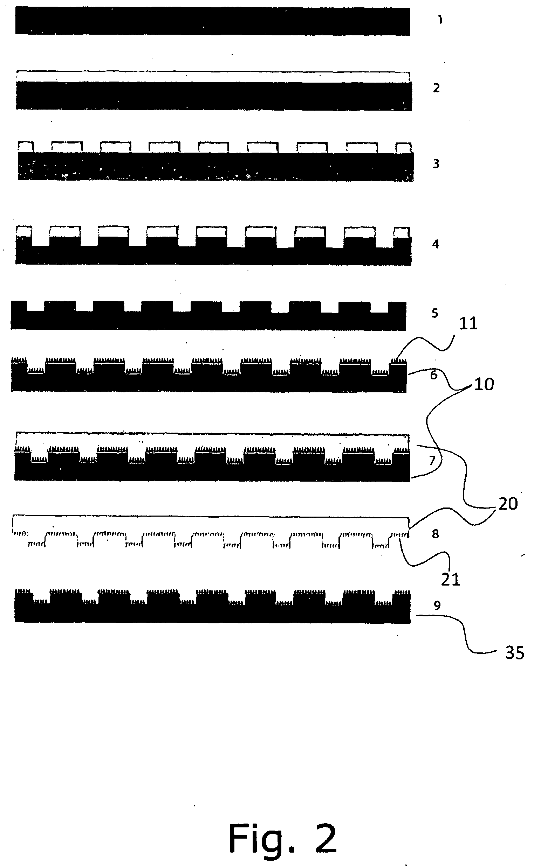

Figure 2 shows schematically a more detailed illustration of a method according to the present invention. The fabrication for the insert 30 with combined nano structures is described step by step as indicated by number 1-9 right of the panel; the size range is 1µm (micrometer) to 100 µm for the micro structures and 50 nm to 2500 nm for the nanostructures (black silicon)

The method has the following steps:
1. The starting point of the insert fabrication is a new wafer of silicon.
2. A resist layer is deposited on the wafer; this could be done by spin coating, spray coating as well as other methods.
3. The microstructures is defined in the resist with lithography e.g. UV, E-beam, Imprint etc. The resist is then developed leaving the structures in the resist layer.
4. The microstructures are transferred to the wafer e.g. by reactive ion etching.
5. The resist layer is stripped leaving the microstructures in the wafer.
6. Black silicon is etched, to produce nano structures having protrusions 11 in the master structure. One of several methods for producing so-called black silicon surfaces is to apply the so-called Bosch process for reactive ion etching (RIE), where a black silicon structure can be achieved by repeatedly switching between etching and passivation.
7. Three options can for example be used to transfer the structures from the wafer to the insert. 1) material depositing such as electroplating 2) imprint lithography, soft lithography, or hot embossing followed by etching by either reactive ion etching, or sputtering, or 3) Casting. As indicated by the corresponding pattern or protrusions 21, as visible and separated in step 8, the protrusions 11 are accordingly transferred from the master 10 into the insert 20.
8. An insert made of softer materials such as aluminium or nickel, cannot withstand as many injection molding cycles as tool steel. The insert therefore may optionally require a hard coating to make it more durable or a coating to make demolding easier.
9. The final step is repeating injection molding or embossing cycles, for the mass production of super hydrophobic/super hydrophilic and self-cleaning polymer parts 35.

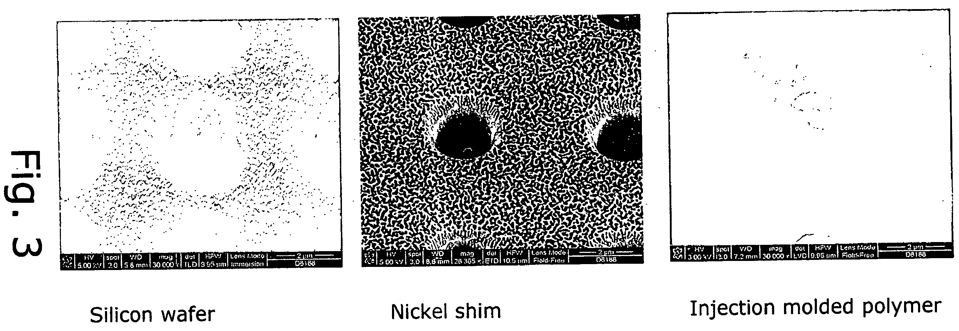

Figure 3 shows three SEM images of a master structure in silicon (left), a nickel shim where the hierarchical structure with nanometre-sized and micrometre-size pattern has been transferred to (middle), and a resulting molded polymer product (right). Notice how the etched shape of the protrusions and the overall hierarchical structure is transferred from the master structure 'negatively' to the nickel shim, and the resulting polymer product therefore being a 'positive' transfer of the silicon master structure.

An injection molding insert with microstructures (circular pillars) in the size range 3 to 7 µm with a pitch 3 to 16 µm (on mask) has been fabricated with photolithography and DRIE of a silicon wafer. In addition nanostructures were added by etching so-called black silicon. The process time was 8 min, gas flow SF6: 70 sccm and 02 :110 sccm. Plasma generators settings was 13.56 MHz coil, 2700W 13.56 MHz, platten 30w and platten (substrate) temperature -10 °C. Further details on producing black silicon can be found in a recent review article by Shieh et al. in Phys. D: Appl. Phys. 44 (2011) 174010'*Plasma-made silicon nanograss and related structures*. Without being bound by any specific theory, it is believed that etching fluorine radicals and passivating oxide radicals are competing, and at a certain level of oxygen there will be created protrusions due to the inherent micromask made up by impurities in the wafer, dust, etc. and the direction of the etching.

The wafer was electroplated with a 320 µm nickel layer. The wafer was removed in 30% KOH at 80°C, leaving a nickel insert with inverse structures.

Injection molding of microscope slides were carried out in a variotherm injection mold tool. The polymer used was Topas® 8007 and polypropylene, an optical profilometer was used to measure the structure height to 3.2 µm, and results for this polymer will also be shown below in Figure 4-11. It should be mentioned that the present inventors has also validated the invention in polypropylene (PP) but results are not shown here.

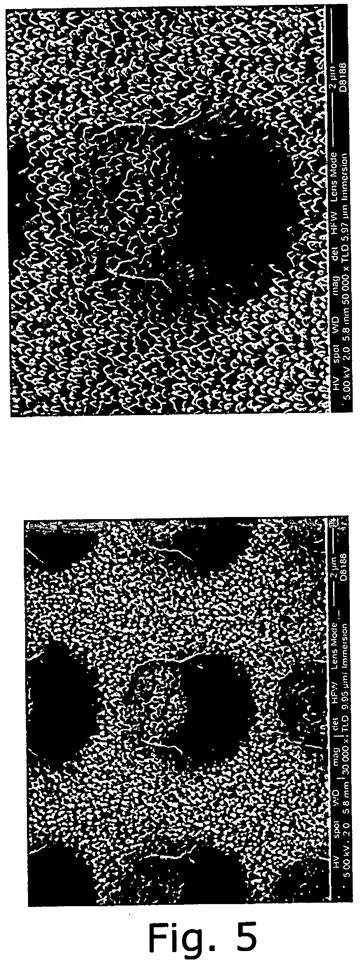

Figures 4 and 5 shows more detailed SEM images of a silicon master structure according to the present invention.

In Figure 4A, a tilted (30°) SEM image of a silicon master with 3 µm micro holes and black silicon protrusions is shown. In Figure 4B, a SEM image of a silicon master with 7 µm holes and black silicon protrusions is shown. In Figure 4C, another tilted (30°) SEM images of black silicon in higher resolution is shown, and in Figure 4D, the same black silicon is seen in a top view.

Figure 5 shows two SEM images with tilted (30°) SEM images of Silicon master with micro pillars i.e. micrometre-sized structures, and black silicon structures i.e. nanometre sized-structures according to the present invention.

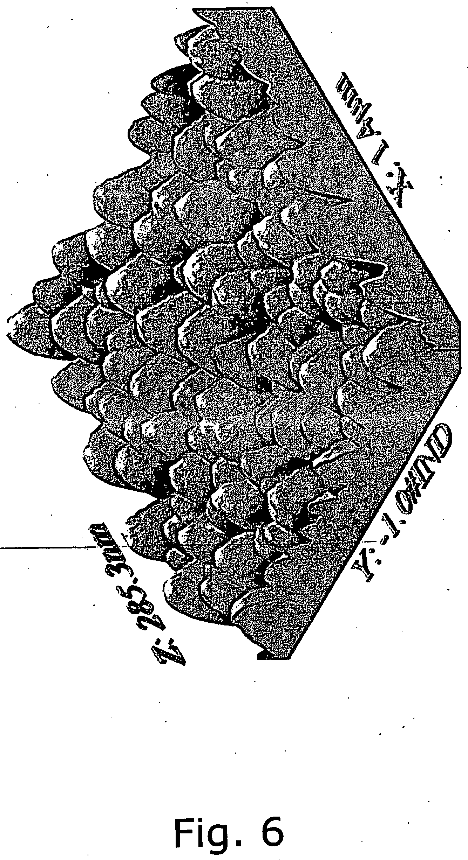

Figure 6 shows a more detailed AFM image of a silicon master structure. The AFM image of black silicon has average height measured to be approximately 70nm.

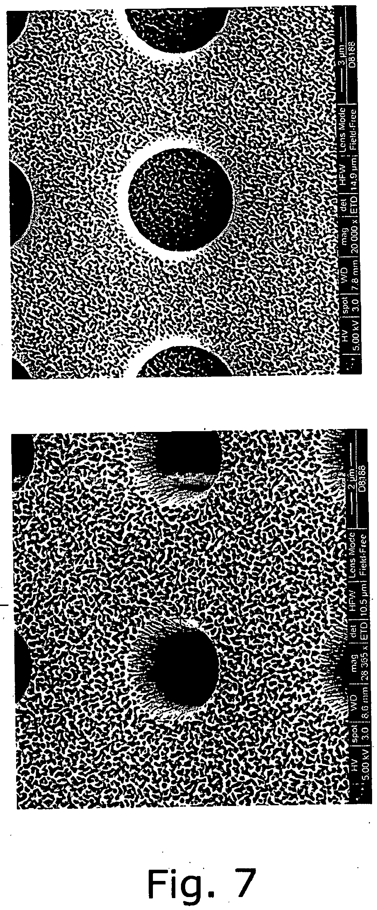

Figure 7 shows SEM images of a Nickel metal insert according to the present invention, with tilted (30°) SEM image of nickel shim with inverse structures, both micro structures and nano structures can be seen to the left. To the right, a corresponding top view.

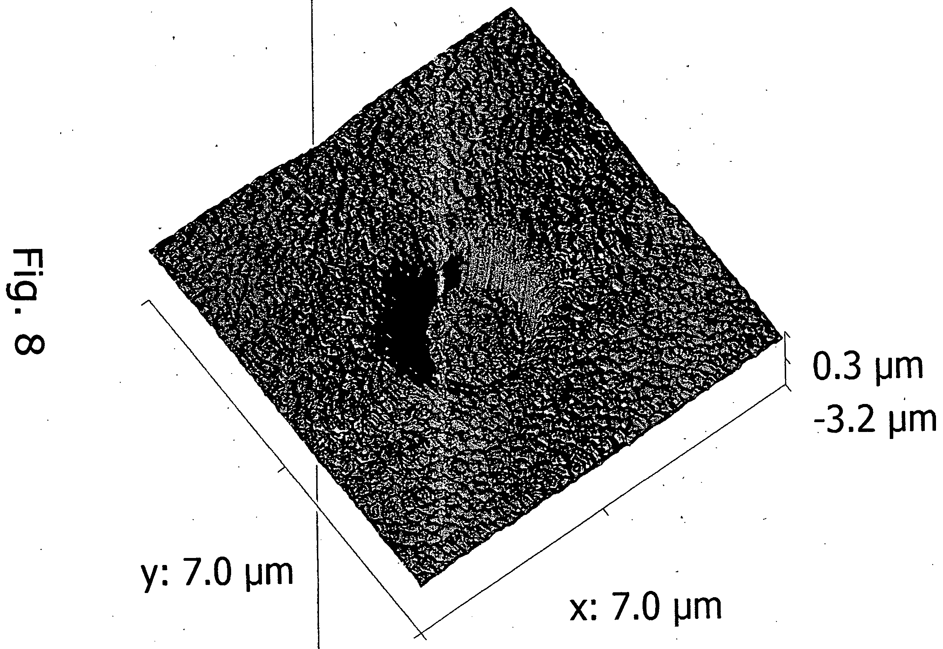

Figure 8 shows a more detailed AFM image of a Nickel metal insert according to the present invention, the AFM image of nickel shim showing inverse structures, micro structures (2.5 µm hole) and also nano structures from the black silicon can be seen.

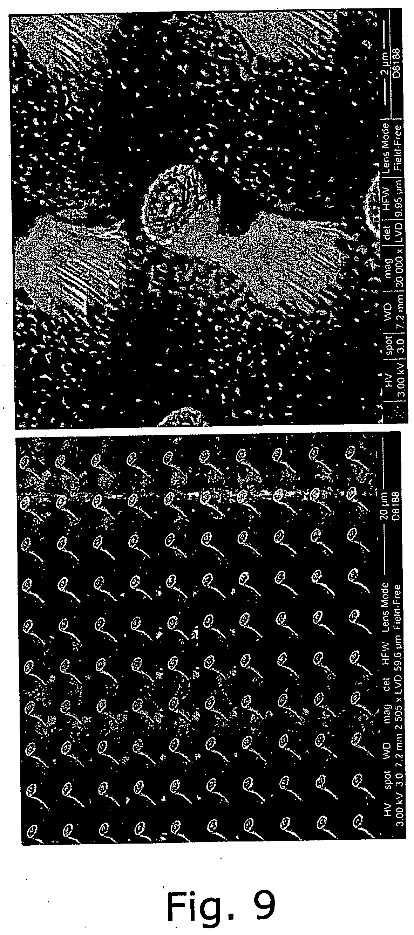

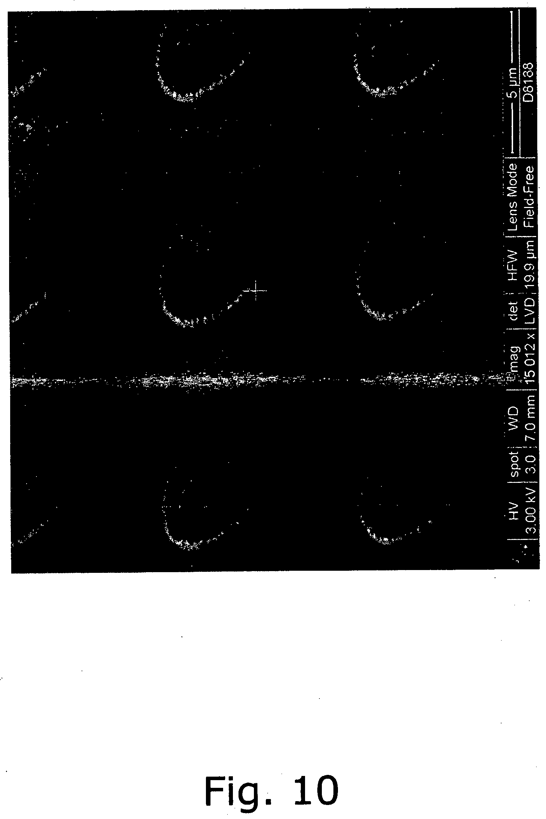

Figures 9 and 10 shows SEM images of a molded polymer product manufactured with tool according to the present invention.

In Figure 9, a tilted (30°) SEM image of an injection molded polymer with 2.5µm pillars and nanostructures (black SI) is shown, in large scale on the left and small scale on the right.

Figure 10 shows a tilted (30°)SEM image of an injection molded polymer with 5 µm pillars and nanostructures (black silicon). Notice how all the pillars are slightly distorted to one side. This is believed to be caused by the extraction of the molding process.

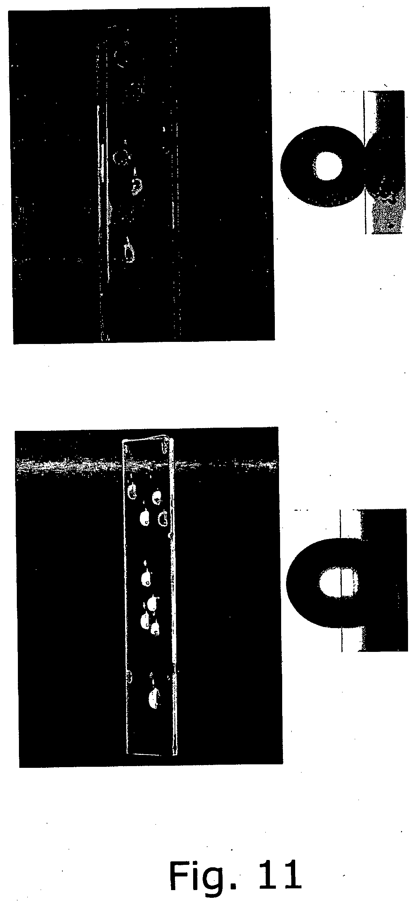

Figure 11 illustrates the result of the wetting experiment for a flat structure without the invention (left) and a polymer product manufactured with tool according to the present invention. The contact angle was measured to 95° for the non-structured (flat) surface. The contact angle increased to 150° for the micro- and nanometer structures. The injection molded microscopes slides shown were also fabricated in Topas® 8007-04.

Roll off angles measurements were also used to describe super hydrophobic and self-cleaning surfaces. The contact angles shown alone are not sufficient to describe a self-cleaning surface since the drops can be pinned on the structured surface. The injection molded test areas had roll off angels down to 1°. It is nearly impossible to deposit a drop on the surface of one of these test areas. This clearly indicates that the drops do not wet the structures and they are in the so-called Cassie Baxter state. Further systematic studies of contamination and self-cleaning experiments are planned.

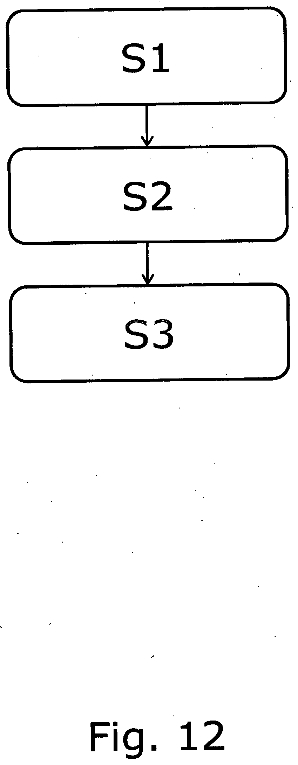

Figure 12 is a schematic system-chart representing an out-line of/in detail the operations of the method for manufacturing a tool part for an injection molding process, a hot embossing process, nano-imprint process or an extrusion process, the method comprises the steps of
**S1** providing a master structure 10 with a surface area comprising nanometre-sized protrusions 11 with a minimum density of approximately 10⁵ protrusions/mm², the protrusions being positioned in a non-periodic, irregular pattern, said protrusions being created by a process comprising:
   alternating passivation and etching into the master structure, and/or
   simultaneous passivation and etching into the master structure, and/or
   etching into the master structure,
**S2** transferring the master structure into a metal insert 20, the metal insert having a corresponding nanometre-sized pattern 21 from said protrusions, and
**S3** adapting the metal insert into a tool part 30 for enabling nanometre-sized patterns being formed by the tool part.

In short, the invention relates to a method for manufacturing a tool part for an injection molding process, a hot embossing process, nano-imprint process or an extrusion process. First, there is provided a master structure 10 with a surface area comprising nanometre-sized protrusions 11 with a minimum density of approximately 10⁵ protrusions/mm², the protrusions being positioned in a non-periodic, irregular pattern, said protrusions being created by a process comprising alternating passivation and etching into the master structure. Secondly, there is made a transfer of the master structure into a metal insert 20, the metal insert having a corresponding nanometre-sized pattern 21 from said protrusions, and thirdly, adapting the metal insert into a tool part 30 for enabling nanometre-sized patterns being formed by the tool part. The invention provides an easier and faster way of manufacturing the master structure, e.g. a black silicon wafer. It is a further advantage of the present invention that it provides an advantageous way of making tools capable of producing self-cleaning surfaces without the need for chemical coating.

The invention can be implemented by means of hardware, software, firmware or any combination of these. The invention or some of the features thereof can also be implemented as software running on one or more data processors and/or digital signal processors.

The individual elements of an embodiment of the invention may be physically, functionally and logically implemented in any suitable way such as in a single unit, in a plurality of units or as part of separate functional units. The invention may be implemented in a single unit, or be both physically and functionally distributed between different units and processors.

Although the present invention has been described in connection with the specified embodiments, it should not be construed as being in any way limited to the presented examples. The scope of the present invention is defined by the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. Method for manufacturing a tool part for an injection molding process, a hot embossing process, nano-imprint process or an extrusion process, the method comprises
providing a semiconductor master structure (10) with a surface area comprising nanometre-sized protrusions (11) with a minimum density of approximately 10⁵ protrusions/mm², the protrusions being positioned in a non-periodic, irregular pattern, said protrusions being created by a process comprising:
alternating passivation and etching into the master structure, and/or
simultaneous passivation and etching into the master structure, and/or
etching into the master structure,
transferring the master structure into a metal insert (20), the metal insert having a corresponding nanometre-sized pattern (21) from said protrusions, and
adapting the metal insert into a tool part (30) for enabling nanometre-sized patterns being formed by the tool part.

2. The method according to claim 1, wherein the process for creating the protrusions result in a random shape and/or a random position with respect to an Individual protrusion.

3. The method according to claim 1, wherein the dimensions of the protrusions are defined by corresponding intervals for each dimension, each dimension being randomly scattered within a corresponding interval, preferably at least one dimension having a scattering of at least 50% of the average value.

4. The method according to claim 1, wherein the process is defined by a set of global process parameters, said parameters being common for the creation of at least a main portion of the protrusions.

5. The method according to claim 1, wherein the process is defined by a set of process parameters, said parameters not being directly related to the size and/or the position of the individual protrusion.

6. The method according to claim 1, wherein the nanometer-sized protrusions being created by the process does not require any lithographic process step for defining shape and/or position of the protrusions, at least for the main part of the protrusions.

7. The method according to claim 1, wherein the passivation comprises the formation of an inert polymer, or an oxide, on the master structure.

8. The method according to claim 1, wherein the etching comprises reactive ion etching (RIE) in the master structure.

9. The method according to claim 1, wherein the etching comprises a wet chemical etching.

10. The method according to claim 1, wherein the etching comprises laser-assisted etching.

11. The method according to claim 1, wherein the master structure is a silicon wafer, and preferably the nanometer-sized protrusions constitute nano-grass and/or black silicon.

12. The method according to claim 1, wherein the master structure comprises a hierarchical structure with a plurality of surface areas comprising nanometre-sized protrusions with a minimum density of 10⁵ protrusions/mm², and a plurality of surface areas comprising micrometer-sized surface structures, the said structures preferably having a characteristic length scale of 1-1000 micrometer, more preferably 1-100 micrometre, even more preferably 2-50 micrometer.

13. The method according to claim 1, wherein transferring the master structure into a metal insert is performed by method chosen from the list consisting of:
• material deposition, such as electroplating
• imprint lithography,
• soft lithography,
• hot embossing combined with etching, and
• casting.

14. The method according to claim 1, wherein transferring the master structure into a metal insert is performed by electrochemical deposition of a shim on the master structure, the shim being used on, or in, the metal insert as a part of the tool part.

## Patentansprüche

1. Verfahren zur Herstellung eines Werkzeugteils für einen Spritzgussvorgang, einen Warmprägevorgang, einen Nanoprägevorgang oder einen Strangpressvorgang, wobei das Verfahren umfasst:
Bereitstellen einer Halbleiter-Master-Struktur (10) mit einer Oberfläche, die Vorsprünge (11) in Nanometergröße mit einer Mindestdichte von etwa 10⁵ Vorsprüngen/mm² umfasst, wobei die Vorsprünge in einem nicht periodischen, unregelmäßigen Muster angeordnet sind, wobei die Vorsprünge durch einen Vorgang geschaffen werden, umfassend:
abwechselndes Passivieren und Ätzen der Master-Struktur, und/oder
gleichzeitiges Passivieren und Ätzen der Master-Struktur,
und/oder
Ätzen der Master-Struktur,
Übertragen der Master-Struktur auf einen Metalleinsatz (20), wobei der Metalleinsatz ein entsprechendes Muster (21) in Nanometergröße aufweist, und
Anpassen des Metalleinsatzes in ein Werkzeugteil (30), das die Ausbildung von Mustern in Nanometergröße durch das Werkzeugteil ermöglicht.

2. Verfahren nach Anspruch 1, wobei der Vorgang zur Schaffung der Vorsprünge zu einer willkürlichen Form und/oder einer willkürlichen Position in Bezug auf einen einzelnen Vorsprung führt.

3. Verfahren nach Anspruch 1, wobei die Abmessungen der Vorsprünge durch entsprechende Intervalle jeder Abmessung festgelegt sind, wobei jede Abmessung willkürlich innerhalb eines entsprechenden Intervalls gestreut ist, wobei vorzugsweise mindestens eine Abmessung eine Streuung von mindestens 50 % des Durchschnittswerts zeigt.

4. Verfahren nach Anspruch 1, wobei der Vorgang durch einen Satz globaler Vorgangsparameter festgelegt ist, wobei die Parameter für die Schaffung mindestens eines Hauptanteils der Vorsprünge gleich sind.

5. Verfahren nach Anspruch 1, wobei der Vorgang durch einen Satz Vorgangsparameter festgelegt ist, wobei die Parameter nicht direkt in Bezug zu der Größe und/oder der Position der einzelnen Vorsprünge stehen.

6. Verfahren nach Anspruch 1, wobei die durch den Vorgang geschaffenen Vorsprünge in Nanometergröße keinen Lithografievorgangsschritt zur Festlegung von Form und/oder Position der Vorsprünge, zumindest des Hauptanteils der Vorsprünge, benötigen.

7. Verfahren nach Anspruch 1, wobei das Passivieren die Bildung eines inerten Polymers oder eines Oxids auf der Master-Struktur umfasst.

8. Verfahren nach Anspruch 1, wobei das Ätzen reaktives Ionenätzen (RIE) der Master-Struktur umfasst.

9. Verfahren nach Anspruch 1, wobei das Ätzen ein nasses chemisches Ätzen umfasst.

10. Verfahren nach Anspruch 1, wobei das Ätzen lasergestütztes Ätzen umfasst.

11. Verfahren nach Anspruch 1, wobei die Master-Struktur ein Silizium-Wafer ist und die Vorsprünge in Nanometergröße aus vorzugsweise Nanogras und/oder schwarzem Silizium bestehen.

12. Verfahren nach Anspruch 1, wobei die Master-Struktur eine hierarchische Struktur mit einer Mehrzahl von Oberflächenbereichen umfassend Vorsprünge in Nanometergröße mit einer Mindestdichte von 10⁵ Vorsprüngen/mm² und eine Mehrzahl von Oberflächenbereichen umfassend Oberflächenstrukturen in Mikrometergröße umfasst, wobei die Strukturen vorzugsweise eine charakteristische Längenskala von 1-1000 Mikrometern, mehr bevorzugt 1-100 Mikrometern und noch mehr bevorzugt 2-50 Mikrometern aufweisen.

13. Verfahren nach Anspruch 1, wobei das Übertragen der Master-Struktur in einen Metalleinsatz mittels eines Verfahrens durchgeführt wird, ausgewählt aus der Liste, bestehend aus:
• Materialabscheidung, wie Galvanotechnik
• Prägelithografie,
• weiche Lithografie,
• Wärmeprägung kombiniert mit Ätzen und
• Gießen.

14. Verfahren nach Anspruch 1, wobei das Übertragen der Master-Struktur in einen Metalleinsatz mittels elektrochemischen Abscheidens einer Zwischenschicht auf der Master-Struktur durchgeführt wird, wobei die Zwischenschicht auf oder in dem Metalleinsatz als ein Teil des Werkzeugteils verwendet wird.

## Revendications

1. Méthode de fabrication d'une pièce d'outil pour un procédé de moulage par injection, un procédé de gaufrage à chaud, un procédé de nano-impression ou un procédé d'extrusion, la méthode comprenant
l'apport d'une structure mère semi-conductrice (10) dont une surface comprend des saillies nanométriques (11) d'une densité minimum d'environ 10⁵ saillies/mm², les saillies étant positionnées selon un motif irrégulier non périodique, lesdites saillies étant créées par un procédé comprenant :
une alternance de passivation et de gravure dans la structure mère, et/ou
une passivation et une gravure simultanées dans la structure mère, et/ou
une gravure dans la structure mère,
le transfert de la structure mère dans un insert métallique (20), l'insert métallique possédant un motif nanométrique (21) correspondant à celui desdites saillies, et
l'adaptation de l'insert métallique dans une pièce d'outil (30) pour que la pièce d'outil puisse former des motifs nanométriques.

2. La méthode selon la revendication 1, dans laquelle le procédé de création des saillies aboutit à une forme aléatoire et/ou une position aléatoire pour une saillie individuelle.

3. La méthode selon la revendication 1, dans laquelle les dimensions des saillies sont définies par des intervalles correspondants pour chaque dimension, chaque dimension présentant une dispersion aléatoire dans un intervalle correspondant, de préférence au moins une dimension présentant une dispersion d'au moins 50 % de la valeur moyenne.

4. La méthode selon la revendication 1, dans laquelle le procédé est défini par un ensemble de paramètres globaux de procédé, lesdits paramètres étant communs pour la création d'au moins une portion principale des saillies.

5. La méthode selon la revendication 1, dans laquelle le procédé est défini par un ensemble de paramètres de procédé, lesdits paramètres n'étant pas directement liés à la taille et/ou à la position de la saillie individuelle.

6. La méthode selon la revendication 1, dans laquelle les saillies nanométriques créées par le procédé ne nécessitent pas d'étape lithographique pour définir la forme et/ou la position des saillies, au moins pour la partie principale des saillies.

7. La méthode selon la revendication 1, dans laquelle la passivation comprend la formation d'un polymère inerte, ou d'un oxyde, sur la structure mère.

8. La méthode selon la revendication 1, dans laquelle la gravure comprend une gravure ionique réactive (GIR) de la structure mère.

9. La méthode selon la revendication 1, dans laquelle la gravure comprend une gravure chimique humide.

10. La méthode selon la revendication 1, dans laquelle la gravure comprend une gravure assistée par laser.

11. La méthode selon la revendication 1, dans laquelle la structure mère est une plaquette de silicium, et de préférence les saillies nanométriques constituent de la nano-herbe et/ou du silicium noir.

12. La méthode selon la revendication 1, dans laquelle la structure mère comprend une structure hiérarchique avec une pluralité de surfaces comprenant des saillies nanométriques avec une densité minimum de 10⁵ saillies/mm², et une pluralité de surfaces comprenant des structures de surface micrométriques, lesdites structures possédant préférablement une échelle de longueur caractéristique de 1 à 1000 micromètres, plus préférablement de 1 à 100 micromètres, encore plus préférablement de 2 à 50 micromètres.

13. La méthode selon la revendication 1, dans laquelle le transfert de la structure mère dans un insert métallique est réalisé par une méthode choisie dans la liste consistant en :
• dépôt de matière, tel que le dépôt électrolytique,
• lithographie par impression,
• lithographie douce,
• gaufrage à chaud, combiné à la gravure, et
• coulée.

14. La méthode selon la revendication 1, dans laquelle le transfert de la structure mère dans un insert métallique est réalisé par dépôt électrochimique d'une cale sur la structure mère, la cale étant utilisée sur, ou dans, l'insert métallique en tant que partie de la pièce d'outil.
